# EUROPEAN PATENT SPECIFICATION

(11) **EP 0 990 380 B1**
(45) Date of publication and mention of the grant of the patent: **22.12.2004**
(21) Application number: 98923200.4
(22) Date of filing: 12.05.1998
(51) Int. Cl.: H05K 13/04, H05K 13/08

(54) **METHOD FOR POSITIONING OF AT LEAST ONE COMPONENT ON A PRINTED CIRCUIT BOARD AND DEVICE FOR CARRYING OUT SUCH METHOD**
VERFAHREN ZUM POSITIONIEREN MINDESTENS EINES BAUTEILS AUF EINER LEITERPLATTE UND VORRICHTUNG UM DIESES VERFAHREN DURCHZUFÜHREN
PROCEDE DE POSITIONNEMENT D'AU MOINS UN COMPOSANT SUR UNE CARTE A CIRCUIT IMPRIME ET DISPOSITIF PERMETTANT DE METTRE EN OEUVRE CE PROCEDE

(30) Priority: 19.06.1997 US 50256 P
(43) Date of publication of application: 05.04.2000
(73) Proprietor: BERG ELECTRONICS MANUFACTURING B.V., 5222 AV s'-Hertogenbosch (NL)
(72) Inventor: FRIEDERICHS, Hendricus, Wilhelmus, Maria, Paulus, NL-3741 HK Baarn (NL)
(74) Representative: de Vries, Johannes Hendrik Fokke
(86) International application number: PCT/NL1998/000262
(87) International publication number: WO 1998/058527

(56) References cited:
- EP-A- 0 293 175
- US-A- 4 486 928
- US-A- 4 631 815

## Description

Method for positioning of at least one component on a printed circuit board, method for handling a component and device for carrying out such method.

### Background

The invention relates to a method for positioning of at least one component on a printed circuit board according to the preamble of claim 1.

The invention also relates to an apparatus according to the preamble of claim 10.

For purposes of the following description, both plug and receptacle connectors are being assumed to have an array of electrical contact portions arranged in a plastic housing, with press-fit contact pins protruding outside the housing, for press-fit connection to plated through holes in the printed circuit board.

According to a prior-art method, connector application to a printed circuit board is conducted in two steps:
1) an initial position of the connector with its press-fit pins with true-position resultant from manufacturing tolerance of terminal stamping, housing cavity deviation, and contact insertion process, with respect to a corresponding array of through-holes on the printed circuit board and the true-position deviation of the holes with respect to the theoretical raster is undertaken;
2) after the positioning of connector, a subsequent operation to apply an insertion force to the connector, whereby the press-fit pins enter the holes until the connector reaches its final position on to the printed circuit board to establish and maintain the mechanical/electrical junction of the contact pins for the useful life of the interconnect.

In the past, to carry out this process, two separate machines, also including an intermediate measuring position, or machines with separate placement and insertion stations have been used to first position the connector on the board and then insert it into the board. The necessity for such arrangements stems from the limitation that the mechanisms for fine positioning or component placement are usually not adapted to develop sufficient force to insert press-fit connectors into printed circuit boards.

Furthermore by the known method a connector pre-positioning frame is necessary, particularly to maintain the pre-assembled connectors in position in the printed circuit board relates to edges, for misalignment and fitting during board press-in, both prior to and during pressure application.

Furthermore if at the measuring station it is determined that a component cannot be used; a new component needs to be picked up and measured. In the mean time the inserting device is idle.

EP 0 293 175 discloses an apparatus for mounting parts on a printed circuit board, wherein the part to be placed is moved by means of a vacuum suction device to a station for measuring the position of the part, after which the part is pressed against the printed circuit board, whose position has been corrected according to positional aberration data of the part.

The objective of the invention is to provide a method whereby the throughput cycle time is reduced and no connector pre-positioning frame is necessary.

The object of the invention is obtained in that the measuring station determines the position of the component with respect to the tool, after which the tool together with the component to be placed is detachably connected to a second positioning device by means of which the component is accurately placed on the desired position on the printed circuit board, after which the tool is disconnected from the component.

According to this method the component remains a fixed position with respect to the tool whilst the tool will be connected to several positioning devices, each having its own function. These functions can be performed simultaneously on different tools. Based on the measurements the component can be accurately placed on the desired position on the printed circuit board by the second positioning device. In the mean time other components can be attached to other or different tools and the positions of those components with respect to the tools to which they are attached can be determined. If it is determined that one or more components need to be rejected due to for example a misalignment of contact pins, the component and the tool connected therewith will not be picked up by the second positioning device. Furthermore a component is placed and can be inserted as well by the second positioning device which makes the working of the second positioning device very efficient.

The objective of the invention is further more to provide a method whereby the orientation of the component has to be determined only once after which the component can be handled as desired.

The objective of the invention is obtained in that the component to be handled is detachable connected to a tool which tool is moved by means of a first device to a measuring station, to determine the position of the component with respect to the tool, after which the tool together with the component to be handled it detachable connected to a second device by means of which the component is handled whereby from the position of the tool with respect to the second device, the position of the component with respect to the second device is known, and after handling of the component the tool is disconnected from the component.

The invention also relates to an apparatus according to the characterising part of Claim 10.

Since the tool has a well known position with reference to the positioning devices to which it is attachable, the position of the component has to be determined only once after which the component together with the tool to which it is attached can be transferred from one positioning device to another whereby the information about the orientation and position of the component is maintained.

A single machine is usable for connector placement on both top and bottom side of the printed circuit board. The rapidity of tool-changeover, from plug to receptacle connectors for example, and the capability to conduct product measurements during machine idle-time, pick-up different products from different packaging, e.g. tubes, tray, etc.. printed circuit board movement and transport, all contribute to an overall application machine efficiency improvement.

### Brief description of the drawings

Fig. 1 is a schematic illustration showing the location and movement of tools in an application machine embodying the invention.
Figs. 2A-I are schematic illustrations of the tooling sequence for a set of three tools.
Fig. 3 is an isometric view of a tool loaded with connector modules, just prior to insertion into a printed circuit board.
Fig. 4 is an isometric view of a first embodiment of a connector application machine.
Fig. 5 is an isometric view of a second embodiment of a connector application machine.
Fig. 6 is an isometric view of a third embodiment of a connector application machine.
Fig. 7 is an exploded view of a connector application machine showing its modular construction.

Like parts are numbered alike in the figures.

### Description of preferred embodiment

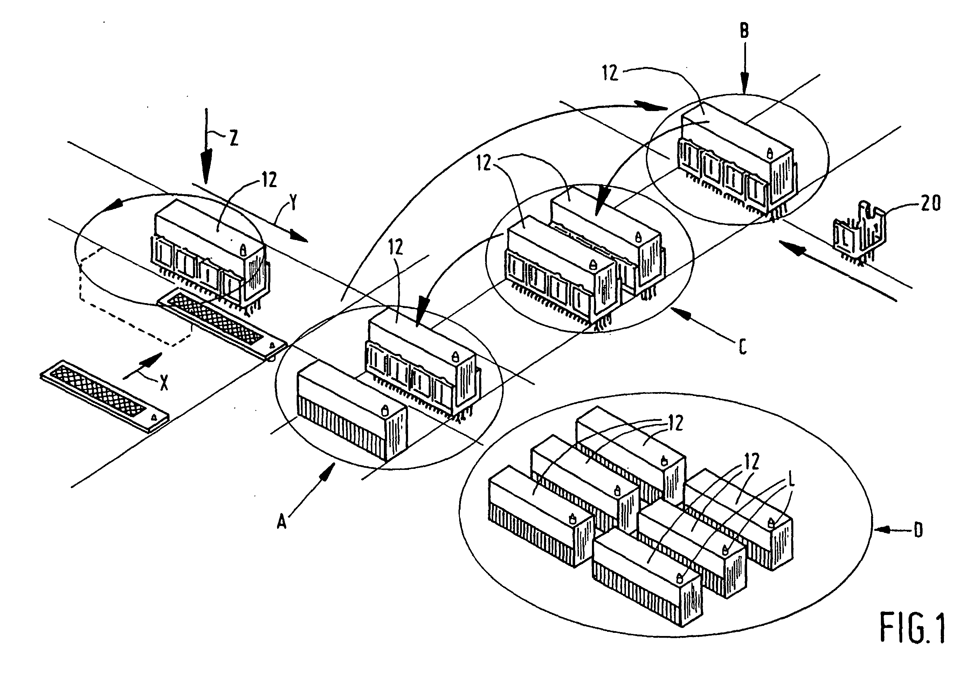

A preferred embodiment of equipment embodying the invention is a machine having a single placement/application head, coupled to a two stage robotic arm that sequentially moves between three stations, as shown in fig. 1. Such equipment is the subject of this description.

### 1. Tooling head movements

In fig. 1 three stations A, B and C are schematically shown. Each product, e.g. plug or receptacle, or group of products to be applied to a printed circuit board has a specific tool 12 fitting the contours of the product housing. Several such tools are located initially in a tool storage bay D. A number of different sets of tools 12, one set for each type of connector or group of connector modules to be applied to the printed circuit board, are stored in storage bay D. Each tool 12 has a reference index point, preferably defined by a locator pin L, used to determine the position of the tool in a user coordinate system resident in the software control system of the equipment. The equipment utilizes a sensing system, optical or otherwise, for sensing the position of locator pins L of each tool 12, and, thus the assembly that comprises the tool 12 and one or more connector modules 20 received on the tool.

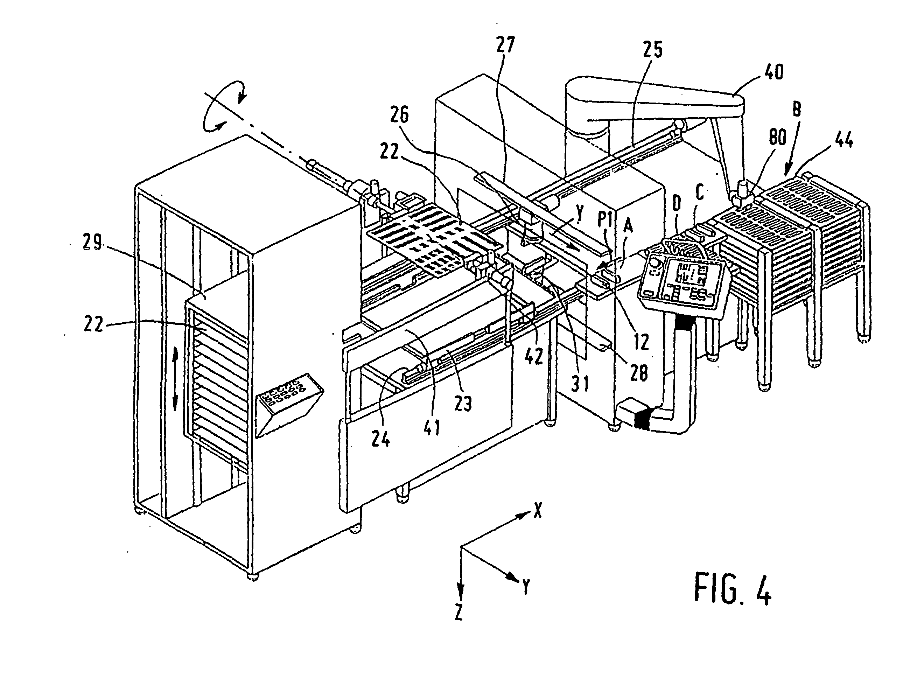

Computer programming resident in controls for the equipment indicates which specific product and its associated packaging tube-tray etc. is to be applied to the printed circuit board. A first robot head moves a specific tool from the storage bay D to station A. A second head may simultaneously pick a product out of packaging and locate the product at loading station B. The tool placed at station A is moved to station B to fit the product which is already available. Alternatively, these operations can be carried out by a single robot head 80 (fig. 4). The robot head 80 transports the tool with associated connector to station C, where an automated vision scanning unit measures the pin true position of all press-fit terminals of the connector with respect to this tool's locater pin L. Alternatively, this measurement step can be carried out as the robot head carries the loaded tool from station B to station A, without stopping at station C. While this measurement procedure is in progress, in the same time duration, the applicator head 26 of the insertion equipment transports the product with its associated tool 12 from station A to a desired printed circuit board location and aligns the product with associated corresponding holes in the printed circuit board. The product is inserted into the board under insertion force applied by the applicator head 26.

It should be noted that from the beginning to the end of applicator cycle, a specific tool is integrated to a specific connector product or group of products. Also the pin position measurements with respect to its index point or locator pin L are unique for one assembled combination. Since this information is supplied to a computer, its unique location with respect to the corresponding printed circuit board hole array can be accurately computer controlled, up to and including the product application process. During this entire application cycle, only one tool is applied to one connector or group of connectors without any intermediary separation of them. Consequently, all measurements and subsequent movements related to the printed circuit board hole array are specific and unique to the specific combination of tool and product. Also, since the connector product is continuously held by the same tool, no loss in positional accuracy between tool and connector, or between the combination and printed circuit board holes is encountered.

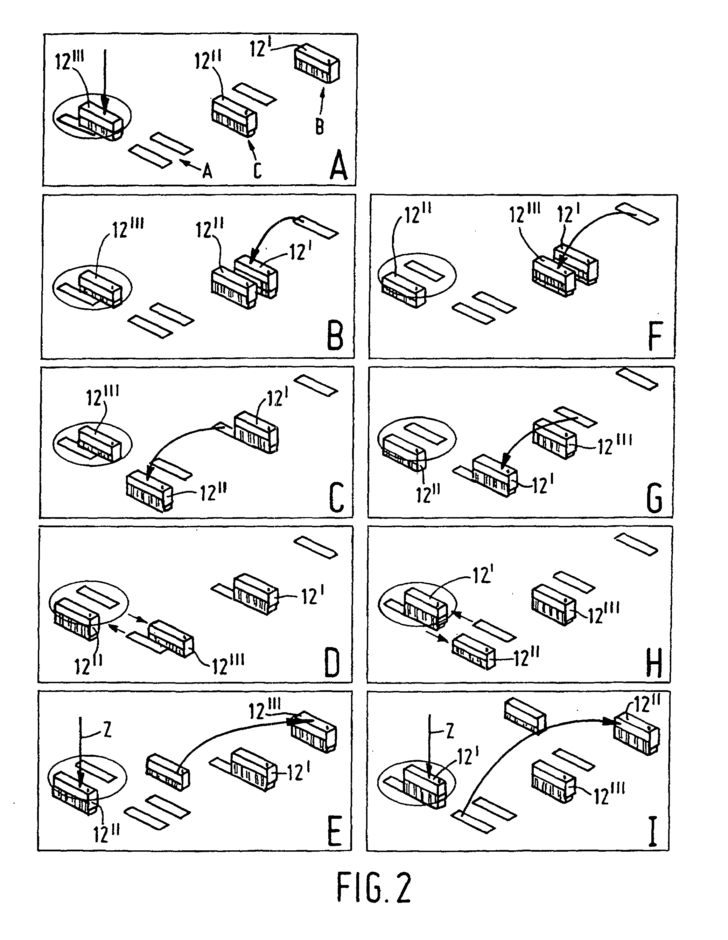

Simultaneously, two robot heads undertake the task between three separate operations by efficiently sub-dividing the redundant time during which the other head is undertaking a separate task. Although the foregoing description has proceeded on the basis of a single connector to be associated with each tool, as shown in figs. 1 and 2, multiple modular connectors 20 can be associated with each tool.

Fi gs. 2A- I show an exempl ary tool i ng movement sequence. Each tool is identified by a discrete number 12', 12" or 12 "'. Each of figs. 2A-I illustrates the operations taking place in one step of the sequence. The location of each tool at each step of the sequence is given in the following table.

| Tool sequence | | | | |
|---|---|---|---|---|
| Step | Product insertion | Station A (application staging) | Product test station C | Product feed station B |
| A | Tool 12''' | -- | Tool 12" | Tool 12' |
| B | Tool 12''' (without connector) | -- | Tools 12' + 12" | -- |
| C | Tool 12''' (without connector) | Tool 12" | Tool 12' | -- |
| D | Tool 12" (transferred) | Tool 12''' (transferred) | Tool 12' | -- |
| E | Tool 12" | -- | Tool 12' | Tool 12''' (transferred) |
| F | Tool 12'' (without connector) | -- | Tools 12' + 12''' | -- |
| G | Tool 12" (without connector) | Tool 12' | Tool 12''' | -- |
| H | Tool 12' (transferred) | Tool 12" (without connector) | Tool 12''' | -- |
| I | Tool 12' | -- | Tool 12''' | Tool 12" (transferred) |

The tooling sequence given in the foregoing table can be modified, as previously suggested, to eliminate the product test station, but not the function. In this case, loaded tools would be transferred from station B directly to station A. Measurement of the true position location of the press-fit terminal pins with respect to locator L is made as the robot 40 (fig. 4) transfers the tooled tool from station B to station A.

The above is a short description of robot head movements to reduce application cycle time and efficiency in movements, resulting in high quality finished boards. Further, since each tool/connector product and its initial associated packaging is considered to be an unique combination, by appropriate computer programming, different products, i.e. plug or receptacle, can be simultaneously applied on the same printed circuit board in one production run. This implies a flexibility, both in tooling and connector product, for production personnel during an application run, without need for cumbersome change-over procedures.

### 2. Product to board error control

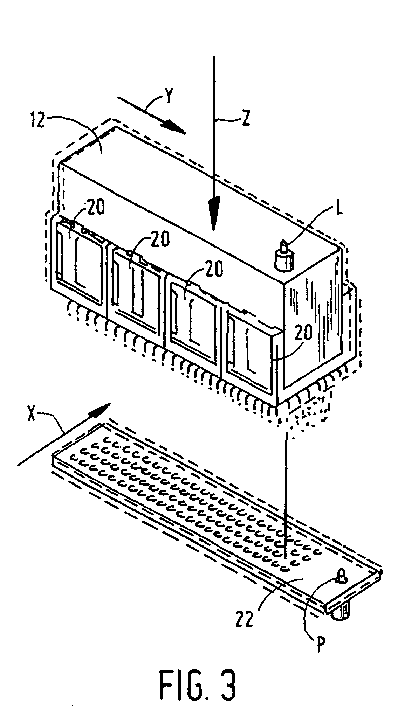

Software manipulation of product true-positioning measurement data can be utilized to increase product positioning accuracy. The computer registers and stores the reference measurement of the hole location on the printed circuit board by use of the board locator pin P (fig. 3). The measurement of a subsequent applied product is compared with that of a previous product. If the deviation between products is large compared to that permitted within accepted values known for hole locations in printed circuit board, as can occur in batch-to-batch variance, the positioning mechanisms will attempt to find an optimum product location, as shown in fig. 3, with the corresponding hole array in a second pass, thus preventing unnecessary loss of an expensive product and process run. The need for a second pass can result from detection of an initial unsuccessful pass to insert the connector(s) in the printed circuit board. Characteristically, insertion is stopped if high insertion force, being indicative of misalignment, is encountered. Routines for position correction to allow insertion are known and are carried out as part of the second pass. The pin P is capable of being sensed by the previously mentioned position detection system. The equipment utilizes the position of the printed circuit board derived from pin P in controlling positioning of the tool 12 with respect to the printed circuit board.

This system allows for statistical analysis and comparison of one product batch with a second batch of the same product. It also gives the opportunity to develop an optimum fit between products and the holes in the printed circuit board. Ultimately, this amounts to a productivity increase.

### 3. Application machine

The application machines illustrated in figs. 3-7 use the basic tool/product movement scheme previously described. They also provide additional features such as ease in accessibility and vision control by operator, board storage and transport in and out from work area, connector packaging options, and the ability to rotate the printed circuit board to allow insertion on both sides.

Fig. 4 illustrates a first embodiment of press-fit application equipment. A printed circuit board 22 is placed in a carrier 23 from a vertically movable magazine 29. The printed circuit board 22 is displaced in the X-direction along rails 24 and 25 by movement of the carrier 23. The equipment is furthermore provided with a product storage station B in which connector products are provided within packaging trays 44, a product testing or measuring station C, a tool storage bay D and a delivery station A. The delivery station A is provided with a transport slide to move tools with or without products connected thereto in a first horizontal direction indicated by arrow P1 and opposite thereto. A working head 26 is displaced in a second horizontal Y-direction over rail 27. This second horizontal direction Y extends perpendicular to the first horizontal direction P1. The equipment includes a sensing system (not shown) at C for sensing the location of the indicator pin L on tools 12 and a printed circuit board locating pin P (fig. 3) mounted on carrier 23. The required position of the printed circuit board 22 in the X-direction before insertion is determined by programming that utilizes position signals derived from pin P and from pin L. Similarly, positioning of working head 26 in the γ-direction is determined by the coordinate system. The Z-direction product movement for pick-up of loaded tools from the slide of delivery station A, press-fit pin insertion into printed circuit board holes and return of unloaded tools on the slide of delivery station A is achieved by a vertical movement of working head 26. After product placement on printed circuit board the empty tool 12 is put back on the slide at delivery station A, the completed board is returned to the magazine 29 and a new board is placed. An anvil placement and tool change head 31, movable in the Y-direction on lower track 28 is located below the working head 26 to support the area of the printed circuit board at which a connector 20 is being inserted by the working head 26. The working head 26 and the head of robot 40 are preferably rotatable about vertical axes, preferably in increments of 90°.

Fig. 4 also shows a Cartesian robot arm 40 having a pick-up head 80 with a capability to move sequentially the loaded and unloaded tools 12 between the storage bay D, product loading station B, testing station C and delivery station A respectively. The printed circuit board can be reversed automatically for two side connector application. This is achieved by lifting the board from its cradle 23 by means of a lifting mechanism, flipping the board over by operation of a motor 42 mounted on the lifting mechanism and subsequently lowering the board onto cradle or carrier 23.

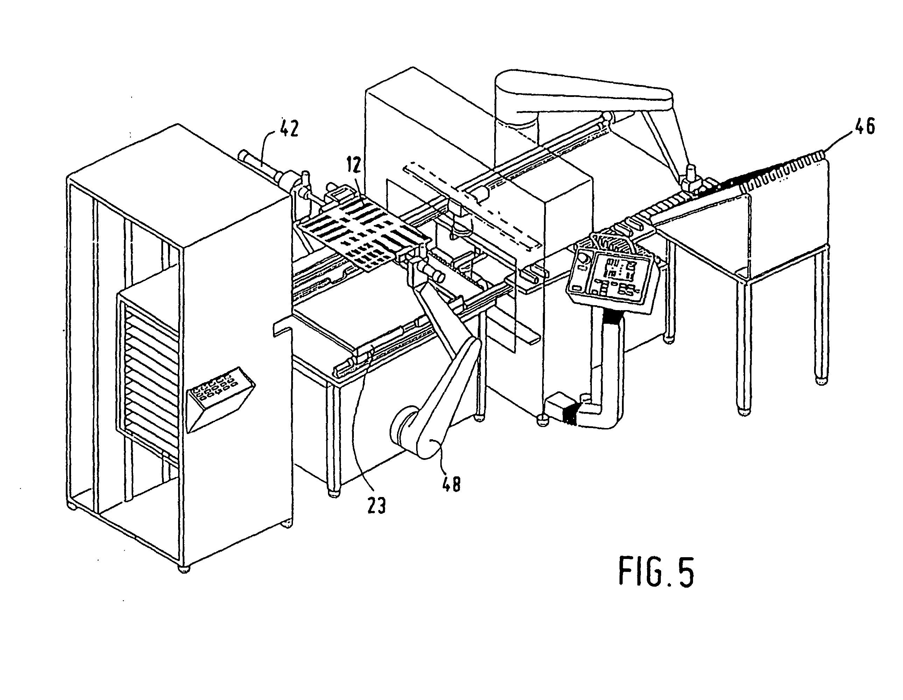

Fig. 5 shows a second machine embodiment with the product being provided in tubes 46. The articulated arm 48 provides the means to raise the printed circuit board 22 from carrier 23 so that the board can be turned over by the motor 42.

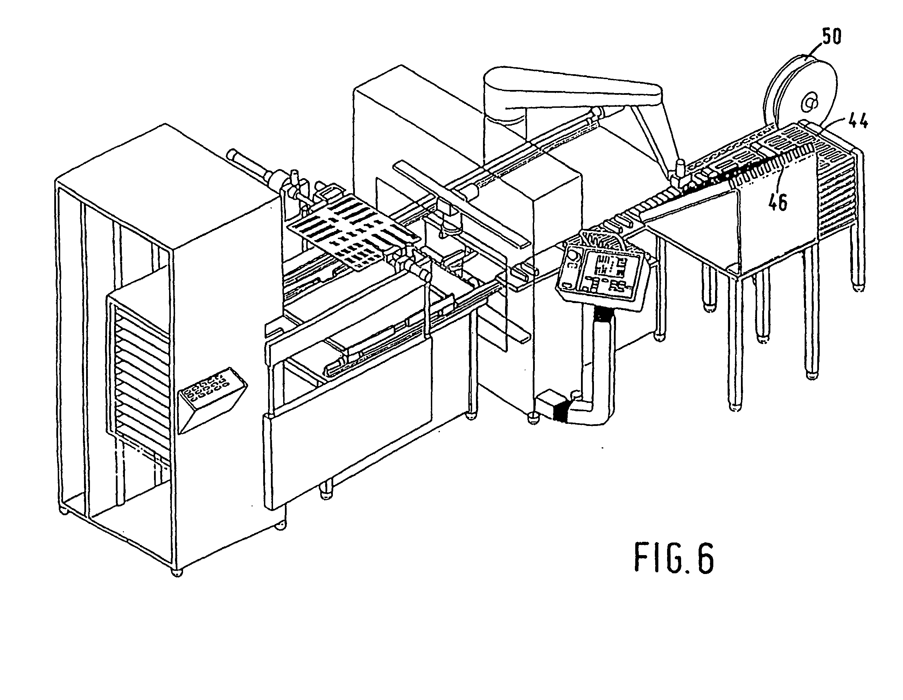

Fig. 6 shows a third machine embodiment capable of removing products simultaneously from trays 44, tubes 46 and blister packaging from a reel 50. Connectors can also be supplied by means of a product configurator that pre-assembles a group of connector modules that are loaded on one of the tools 12. Such configuration is disclosed in provisional application Serial No. US 60/050.251 entitled pre-positioning product configurator, filed on July 19, 1997.

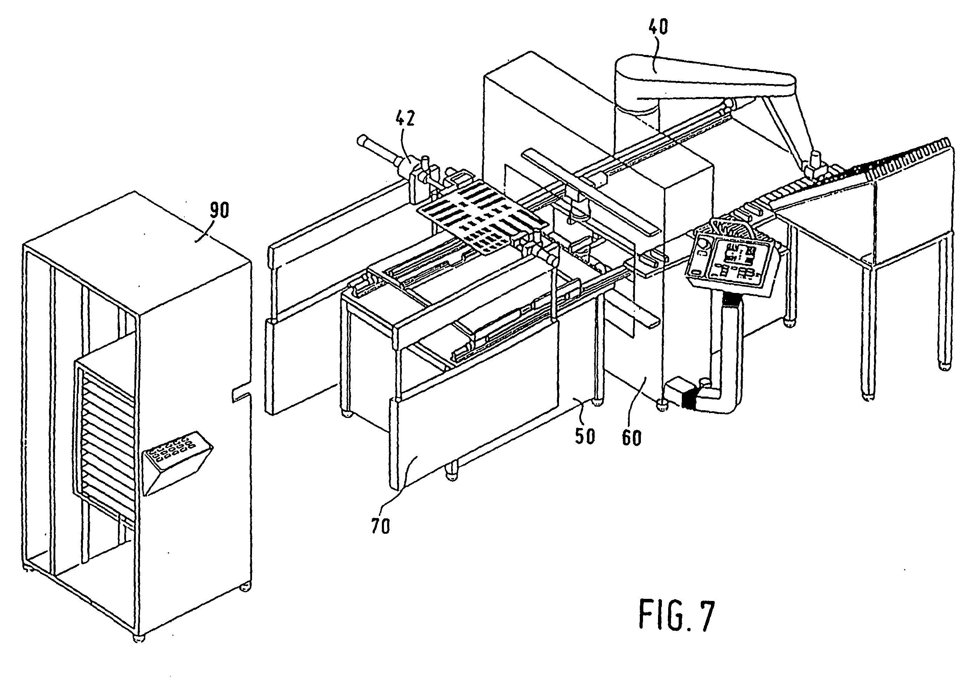

Finally, fig. 7 shows the modular build-up of the machine units. The basic application equipment comprises the printed circuit board table and insertion unit comprising the elements 50 and 60. To this assembly is added the Cartesian robot 40. A board turning unit 70 can be added to unit 50 for making double-sided printed circuit boards. A printed circuit board magazine unit 90 can be added for automatic printed circuit board feeding.

## Claims

1. Method for positioning of at least one component (20) on a printed circuit board (22), wherein the component (20) to be placed is detachably connected to a tool (12) which tool is moved by means of a first positioning device (40) to a measuring station (C) for determining the position of the component (20) with respect to the tool (12)
**characterized in that**
thereafter the tool (12) together with the component (20) to be placed is detachably connected to a second positioning device (26) by means of which the component (20) is accurately placed on the desired position on the printed circuit board (22), after which the tool (12) is disconnected from the component (20).

2. Method according to claim 1, **characterized in that** the tool (12) is provided with an index point (L), whereby the position of the component (20) is determined with reference to said index point (L).

3. Method according to claim 1 or 2, **characterized in that** the component (20) is provided with electrical contact pins, whereby the positions of the contact pins are determined with respect to said tool (12).

4. Method according to one of the preceding claims,
**characterized in that** the desired position of the printed circuit board (22) is determined with reference to said second positioning device (26).

5. Method according to one of the preceding claims,
**characterized in that** by means of the second positioning device (26), the contact pins are press-fitted into holes of the printed circuit board (22).

6. Method according to one of the preceding claims,
**characterized in that** by means of the first positioning device (40) a tool (12) suitable for the component (20) to be placed is picked up from a tool storage station (D), after which the tool (12) is connected to the component (20) to be placed.

7. Method according to one of the preceding claims,
**characterized in that** several components (20) are attached to one tool (12).

8. Method according to one of the preceding claims,
**characterized in that** the tool (12) together with the component (20) to be placed is moved over the measuring station (C) during which movement the position of the component (20) with respect to the tool (12) is determined.

9. Method according to one of the preceding claims,
**characterized in that** in the measuring station (C) the correct functioning of the component (20) to be placed is tested.

10. Apparatus for positioning of at least one component (20) on a printed circuit board (22), comprising a tool (12), a first positioning device (40), and a measuring station (C), wherein the component (20) to be placed is detachably connectable to the tool (12) which tool is movable by means of the first positioning device (40) to the measuring station (C) adapted to determine the position of the component (20) with respect to the tool (12) ,
**characterized in that** the apparatus further comprising a second positioning device (26) and wherein the tool (12) together with the component (20) to be placed is detachably connectable to the second positioning device (26) by means of which the component (20) can be accurately placed on the desired position on the printed circuit board (22), after which the tool (12) is disconnectable from the component (20).

11. Apparatus according to claim 10 suitable for carrying out the method according to one of the claims 2-9.

12. Apparatus according to claim 10, **characterized in that** the apparatus is provided with a delivery station (A) for at least storage of tools (12) with components (20) to be placed, from which the position with respect to the tool (12) has been determined, in which delivery station (A) the tools (12) are movable in a first horizontal direction (X), whilst the second positioning device (26) is movable in a second horizontal direction (Y) extending perpendicular to the first horizontal direction (X).

13. Apparatus according to one of the claims 10-12,
**characterized in that** the apparatus is provided with a sensing system for locating the position of the tool (12).

14. Apparatus according to claim 13, **characterized in that** the tool (12) is provided with an index point (L) capable of being sensed by the sensing system.

## Patentansprüche

1. Verfahren zum Positionieren mindestens eines Bauteils (20) auf einer Leiterplatte (22), wobei das anzubringende Bauteil (20) abnehmbar mit einem Werkzeug (12) verbunden ist, wobei das Werkzeug durch eine erste Positioniervorrichtung (40) zu einer Messstation (C) bewegt wird, um die Position des Bauteils (20) in Bezug auf das Werkzeug (12) zu bestimmen,
**dadurch gekennzeichnet, dass**
das Werkzeug (12) anschließend zusammen mit dem anzubringenden Bauteil (20) abnehmbar mit einer zweiten Positioniervorrichtung (26) verbunden wird, mit deren Hilfe das Bauteil (20) präzise an der gewünschten Stelle auf der Leiterplatte (22) angeordnet wird, wonach das Werkzeug (12) vom Bauteil (20) getrennt wird.

2. Verfahren nach Anspruch 1, **dadurch gekennzeichnet, dass** das Werkzeug (12) mit einem Indexpunkt (L) versehen ist, wobei die Position des Bauteils (20) mit Bezug auf den Indexpunkt (L) festgelegt wird.

3. Verfahren nach Anspruch 1 oder 2, **dadurch gekennzeichnet, dass** das Bauteil (20) mit elektrischen Kontaktstiften versehen ist, wobei die Positionen der Kontaktstifte in Bezug auf das Werkzeug (12) festgelegt sind.

4. Verfahren nach einem der vorhergehenden Ansprüche, **dadurch gekennzeichnet, dass** die gewünschte Position der Leiterplatte (22) in Bezug auf die zweite Positioniervorrichtung (26) festgelegt ist.

5. Verfahren nach einem der vorhergehenden Ansprüche, **dadurch gekennzeichnet, dass** die Kontaktstifte mit Hilfe der zweiten Positioniervorrichtung (26) in Löcher der Leiterplatte (22) eingepasst werden.

6. Verfahren nach einem der vorhergehenden Ansprüche, **dadurch gekennzeichnet, dass** ein für das Bauteil (20) geeignetes Werkzeug (12) mit Hilfe der ersten Positioniervorrichtung (40) von einem Werkzeugablageplatz (D) genommen wird, wonach das Werkzeug (12) mit dem anzubringenden Bauteil (20) verbunden wird.

7. Verfahren nach einem der vorhergehenden Ansprüche, **dadurch gekennzeichnet, dass** verschiedene Bauteile (20) an einem Werkzeug (12) befestigt sind.

8. Verfahren nach einem der vorhergehenden Ansprüche, **dadurch gekennzeichnet, dass** das Werkzeug (12) zusammen mit dem anzubringenden Bauteil (20) über der Messstation (C) verschoben wird, wobei während dieser Bewegung die Position des Bauteils (20) in Bezug auf das Werkzeug (12) festgelegt wird.

9. Verfahren nach einem der vorhergehenden Ansprüche, **dadurch gekennzeichnet, dass** der ordnungsgemäße Betrieb des anzubringenden Bauteils (20) in der Messstation (C) geprüft wird.

10. Vorrichtung zum Positionieren mindestens eines Bauteils (20) auf eine Leiterplatte (22), mit einem Werkzeug (12), einer ersten Positioniervorrichtung (40) und einer Messstation (C), wobei das anzubringende Bauteil (20) abnehmbar mit dem Werkzeug (12) verbindbar ist, wobei das Werkzeug durch die erste Positioniervorrichtung (40) zu der Messstation (C) bewegt wird, die ausgelegt ist, um die Position des Bauteils (20) in Bezug auf das Werkzeug (12) zu bestimmen,
**dadurch gekennzeichnet, dass**
die Vorrichtung ferner eine zweite Positioniervorrichtung (26) aufweist und wobei das Werkzeug (12) zusammen mit dem anzubringenden Bauteil (20) abnehmbar mit der zweiten Positioniervorrichtung (26) verbindbar ist, mit deren Hilfe das Bauteil (20) präzise an der gewünschten Stelle auf der Leiterplatte (22) positioniert werden kann, wonach das Werkzeug (12) vom Bauteil (20) getrennt wird.

11. Vorrichtung nach Anspruch 10, dazu geeignet, das Verfahren nach einem der Ansprüche 2-9 durchzuführen.

12. Vorrichtung nach Anspruch 10, **dadurch gekennzeichnet, dass** die Vorrichtung mit einer Abgabestation (A) ausgerüstet ist, zumindest zum Ablegen von Werkzeugen (12) mit anzubringenden Bauteilen (20), von der die Position in Bezug auf das Werkzeug (12) festgelegt wurde, wobei in dieser Abgabestation (A) die Werkzeuge (12) in einer ersten waagrechten Richtung (X) beweglich sind, während die zweite Positioniervorrichtung (26) in einer zweiten waagerechten Richtung (Y) beweglich ist, die sich rechtwinklig zur ersten waagrechten Richtung (X) erstreckt.

13. Vorrichtung nach einem der Ansprüche 10 bis 12, **dadurch gekennzeichnet, dass** die Vorrichtung mit einem Abtastsystem ausgerüstet ist, um die Position des Werkzeugs (12) zu lokalisieren.

14. Vorrichtung nach Anspruch 13, **dadurch gekennzeichnet, dass** das Werkzeug (12) mit einem Indexpunkt (L) ausgerüstet ist, der vom Abtastsystem abgetastet werden kann.

## Revendications

1. Procédé de positionnement d'au moins un composant (20) sur une carte de circuit imprimé (22), pour lequel le composant (20) à placer est assujetti, de manière amovible, sur un outil (12), lequel outil est déplacé au moyen d'un premier dispositif de positionnement (40) jusqu'à une station de mesure (C) pour déterminer la position du composant (20) relativement à l'outil (12), **caractérisé en ce que**,
ensuite, l'outil (12) avec le composant (20) à placer est assujetti, de manière amovible, sur un deuxième dispositif de positionnement (26) au moyen duquel le composant (20) est précisément placé à la position voulue sur la carte de circuit imprimé (22), après quoi l'outil (12) est déchargé du composant (20).

2. Procédé selon la revendication 1, **caractérisé en ce que** l'outil (12) est pourvu d'un point d'indexation (L), grâce auquel la position du composant (20) est déterminée par référence audit point d'indexation (L).

3. Procédé selon la revendication 1 ou 2, **caractérisé en ce que** le composant (20) est pourvu de broches de contact électrique, grâce auxquelles les positions des broches de contact sont déterminées relativement audit outil (12).

4. Procédé selon l'une des revendications précédentes, **caractérisé en ce que** la position voulue de la carte de circuit imprimé (22) est déterminée par référence audit deuxième dispositif de positionnement (26).

5. Procédé selon l'une des revendications précédentes, **caractérisé en ce que**, au moyen du deuxième dispositif de positionnement (26), les broches de contact sont ajustées à la presse dans des trous de la carte de circuit imprimé (22).

6. Procédé selon l'une des revendications précédentes, **caractérisé en ce que**, au moyen du premier dispositif de positionnement (40), un outil (12), adéquat pour le composant (20) à placer, est prélevé depuis une station de stockage d'outil (D), après quoi l'outil (12) est assujetti au composant (20) à placer.

7. Procédé selon l'une des revendications précédentes, **caractérisé en ce que** plusieurs composants (20) sont assujettis sur un outil (12).

8. Procédé selon l'une des revendications précédentes, **caractérisé en ce que** l'outil (12) avec le composant (20) à placer est déplacé au-dessus de la station de mesure (C), déplacement au cours duquel la position du composant (20) relativement à l'outil (12) est déterminée.

9. Procédé selon l'une des revendications précédentes, **caractérisé en ce que**, à la station de mesure (C), le fonctionnement correct du composant (20) à placer fait l'objet d'un essai.

10. Appareil de positionnement d'au moins un composant (20) sur une carte de circuit imprimé (22), comprenant un outil (12), un premier dispositif de positionnement (40), une station de mesure (C), par lequel le composant (20) à placer est susceptible d'être assujetti, de manière amovible, sur l'outil (12), lequel outil est mobile au moyen du premier dispositif de positionnement (40) jusqu'à la station de mesure (C) adaptée à déterminer la position du composant (20) relativement à l'outil (12), **caractérisé en ce que**,
l'appareil comprend en outre un deuxième dispositif de positionnement (26) et dans lequel l'outil (12), avec le composant (20) à placer, est susceptible d'être assujetti, de manière amovible, sur le deuxième dispositif de positionnement (26) au moyen duquel le composant (20) peut être précisément placé à la position voulue sur la carte de circuit imprimé (22), après quoi l'outil (12) est susceptible d'être déchargé du composant (20).

11. Appareil selon la revendication 10, adéquat pour mettre en oeuvre le procédé selon l'une des revendications 2 à 9.

12. Appareil selon la revendication 10, **caractérisé en ce que** l'appareil est muni d'une station de fourniture (A) pour au moins un stockage d'outils (12) avec des composants (20) à placer, à partir de laquelle la position relativement à l'outil (12) a été déterminée, dans laquelle station de fourniture (A) les outils (12) sont mobiles dans une première direction horizontale (X), alors que le deuxième dispositif de positionnement (26) est mobile dans une deuxième direction horizontale (Y) s'étendant perpendiculairement à la première direction horizontale (X).

13. Appareil selon l'une des revendications 10 à 12, **caractérisé en ce que** l'appareil est pourvu d'un système de détection pour localiser la position de l'outil (12).

14. Appareil selon la revendication 13, **caractérisé en ce que** l'outil (12) est pourvu d'un point d'indexation (L) susceptible d'être détecté par le système de détection.
